# DEMANDE DE BREVET EUROPEEN

(11) **EP 4 644 166 A1**
(43) Date de publication de la demande: **05.11.2025**
(21) Numéro de dépôt: 25173254.1
(22) Date de dépôt: 29.04.2025
(51) Int. Cl.: B60L 53/60, H05K 1/02, G01R 19/00, B60M 1/00, B60M 3/00, H05K 3/36

(54) **DISPOSITIF DE CARTE A CIRCUIT IMPRIME PERMETTANT LA MESURE D'AU MOINS UNE GRANDEUR ELECTRIQUE**

(30) Priorité: 30.04.2024 FR 2404529
(71) Demandeur: HAGER CONTROLS, 67700 Saverne (FR)
(72) Inventeur: KEITA, El hadji Malik, 67170 Brumath (FR); MISSLER, Jean-Luc, 57720 Obergailbach (FR); MONIOT, Frédéric, 67200 Strasbourg (FR); PHAN, Anne-Claire, 67700 Saverne (FR); WOHLFAHRT, Thomas, 67330 Dossenheim-Sur-Zinsel (FR)
(74) Mandataire: Ipsilon

(57) **Abrégé**

La présente invention a pour objet un dispositif de carte à circuit imprimé permettant la mesure d'au moins une grandeur électrique, ledit dispositif comprenant une carte à circuit imprimé (1), dite carte mère (1), présentant une face, dite face (1a) principale, un dispositif de mesure permettant de mesurer au moins une grandeur électrique et de générer des signaux de mesure et au moins une piste conductrice (3) du courant pour la mesure.

Il se caractérise en ce qu'il comprend en outre une carte à circuit imprimé additionnel, dite carte fille (2), présentant deux faces opposées et étant connectée directement sur la face (1a) principale de la carte mère (1) en étant maintenue sensiblement perpendiculairement par rapport à la carte mère (1), en ce que la ou chaque piste conductrice (3) comprend une partie principale (30, 30') s'étendant sur la face principale (1a) de la carte mère (1) et une partie de transition s'étendant sur les deux faces (20, 20') de la carte fille (2) en la traversant, la partie principale (30, 30') comprenant deux segments principaux (30, 30') de part et d'autre de la carte fille (2), chacun relié, par une liaison conductrice (8), à la partie de transition de ladite piste conductrice (3) et en ce que le dispositif de mesure est implanté sur la carte fille (2) en étant relié à la ou l'une des parties de transition conductrice(s).

## Description

La présente invention concerne le domaine des cartes à circuit imprimé, plus particulièrement des cartes à circuit imprimé utilisées dans le domaine des équipements électriques résidentiels et tertiaires et de l'alimentation en énergie électrique des véhicules. Elle a pour objet un dispositif de carte à circuit imprimé permettant la mesure d'au moins une grandeur électrique.

Dans la présente demande on entend par « circuit imprimé » tout type de structure physique de circuits comprenant un substrat isolant (ou support isolant ou base) et au moins une couche conductrice du courant électrique fixée en permanence sur et/ou dans le substrat isolant.

Dans un tel circuit imprimé, également appelé carte électronique, les couches conductrices forment des pistes conductrices (ou des chemins ou parcours conducteurs) du courant électrique permettant de relier des composants électroniques ou électriques maintenus sur la surface du substrat isolant ou entre deux couches conductrices. La connexion des composants en surface est réalisée généralement par un procédé d'assemblage permanent appelé brasage établissant, à l'aide d'un métal d'apport, une liaison métallique entre le composant et la piste conductrice et dont le résultat est la brasure. Le « circuit imprimé » est enfin généralement recouvert d'une couche de protection telle qu'un vernis, protégeant les pistes conductrices et est réalisé par traitement mécanique et/ou chimique d'une feuille, pâte ou pellicule conductrices sur un support isolant.

On connait également des cartes à circuit imprimé, appelées cartes mères, qui sont connectées à une autre carte à circuit imprimé, appelée carte fille. La connexion entre les deux cartes, la carte mère et la carte fille, est généralement réalisée à l'aide de connecteurs comportant des contacts électriques permettant de relier électriquement la carte mère à la carte fille.

On sait que dans le domaine des équipements électriques dans les bâtiments résidentiels, tertiaires ou industriels ou sur les sites par exemple dédiés à la recharge des véhicules électriques, ces équipements utilisent de plus en plus des cartes électroniques pour leur fonctionnement. C'est le cas plus particulièrement le cas, dans le domaine de la recharge des véhicules électrique (par exemple des bornes de recharge) qui utilisent des cartes électroniques de puissance et/ou de contrôle de la charge des véhicules électriques. C'est également le cas des compteurs électriques nouvelles génération qui utilisent des cartes électroniques.

Ces cartes électroniques comportent généralement des circuits de mesure permettant de mesurer des grandeurs/paramètres électriques/physiques telles que le courant, la tension ou la puissance. Toutefois, ces circuits de mesure, notamment à base de tores, occupent un espace important sur la carte électronique, notamment lorsque les cartes électroniques sont parcourues par des courants de forte intensité (par exemple entre 16A et 32A) comme c'est le cas pour les cartes électroniques utilisées dans le domaine de la recharge des véhicules électriques ou des compteurs électriques. En outre, ces circuits de mesures entraînent fréquemment, notamment en présence de tels courants forts des problèmes d'échauffement qui peuvent détériorer les composants environnants de la carte électronique.

La présente invention a pour but de pallier ces inconvénients.

A cet effet, la présente invention a pour objet un dispositif de carte à circuit imprimé permettant la mesure d'au moins une grandeur électrique, ledit dispositif comprenant une carte à circuit imprimé, dite carte mère, présentant une face, dite face principale, un dispositif de mesure permettant de mesurer au moins une grandeur électrique et de générer des signaux de mesure et au moins une piste conductrice du courant pour la mesure, se caractérisant en ce qu'il comprend en outre une carte à circuit imprimé additionnel, dite carte fille, présentant deux faces opposées, à savoir une première face et une deuxième face et étant connectée directement sur la face principale de la carte mère en étant maintenue sensiblement perpendiculairement par rapport à la carte mère, en ce que la ou chaque piste conductrice comprend une partie principale s'étendant sur la face principale de la carte mère et une partie de transition s'étendant sur les deux faces de la carte fille en la traversant, la partie principale comprenant deux segments principaux de part et d'autre de la carte fille, à savoir un premier segment principal et un second segment principal, chacun relié, par une liaison conductrice, à la partie de transition de ladite piste conductrice et en ce que le dispositif de mesure est implanté sur la carte fille en étant relié à la ou l'une des parties de transition conductrice(s).

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :
[Fig. 1] est une vue en perspective d'un dispositif de carte à circuit imprimé selon la présente invention, montrant l'une des faces, dite première face, de la carte fille,
[Fig. 2] est une vue de face de la carte fille telle que représentée sur la figue 1,
[Fig. 3] est vue en perspective du dispositif de carte à circuit imprimé représenté sur la figure 1 dans une orientation opposée montrant l'autre face, dite deuxième face, de la carte fille,
[Fig. 4] est une vue de face de la carte fille telle que représentée sur la figure 3.

Les figures annexées montrent un dispositif de carte à circuit imprimé permettant la mesure d'au moins une grandeur électrique, ledit dispositif comprenant une carte à circuit imprimé 1, dite carte mère 1, présentant une face, dite face 1a principale, un dispositif de mesure permettant de mesurer au moins une grandeur électrique et de générer des signaux de mesure et au moins une piste conductrice 3 du courant pour la mesure (ou apte et destiné à être, ou étant, parcourue par un courant (ou flux électrique) à mesurer).

Le terme « courant » peut être défini comme le flux ou le mouvement de charges électriques, notamment des électrons, dans la ou chaque piste conductrice 3 ou autre élément conducteur (fil électrique, composant électrique/électronique, par exemple) du dispositif de carte à circuit imprimé.

Conformément à la présente invention, un tel dispositif de carte à circuit imprimé comprend en outre une carte à circuit imprimé additionnel, dite carte fille 2, présentant deux faces opposées, à savoir une première face 20 et une deuxième face 20'. La carte fille 2 est connectée directement sur la face 1a principale de la carte mère 1 et est maintenue sensiblement perpendiculairement (ou sensiblement à 90°) par rapport à la carte mère 1.

On entend par « sensiblement perpendiculairement » (ou sensiblement à 90°), un angle entre les deux cartes mère 1 et filles 2 (leurs plans respectifs) faisant 90° ou approchant 90°.

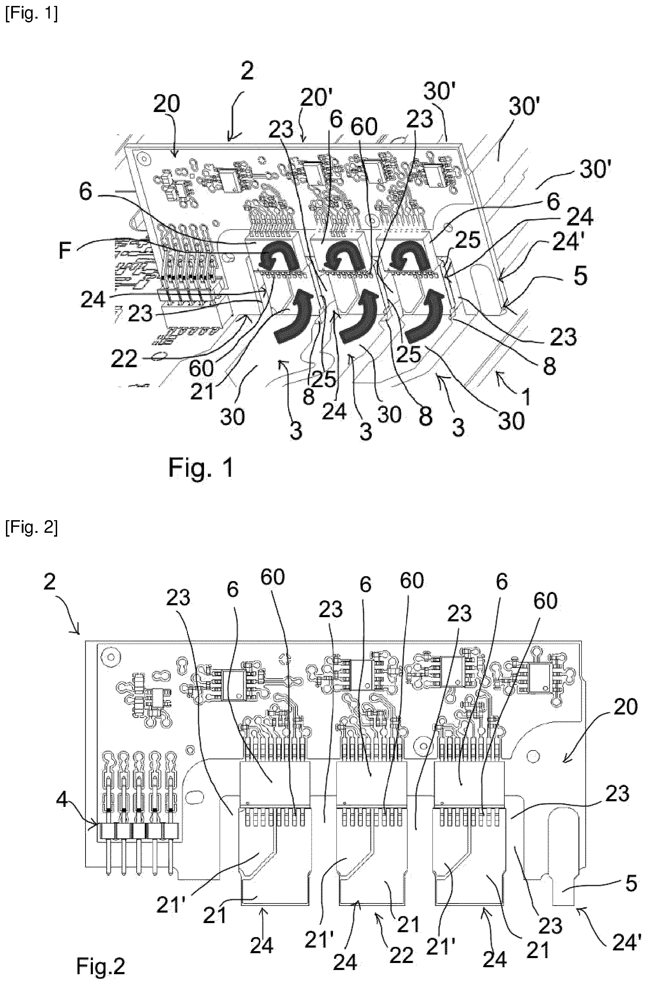

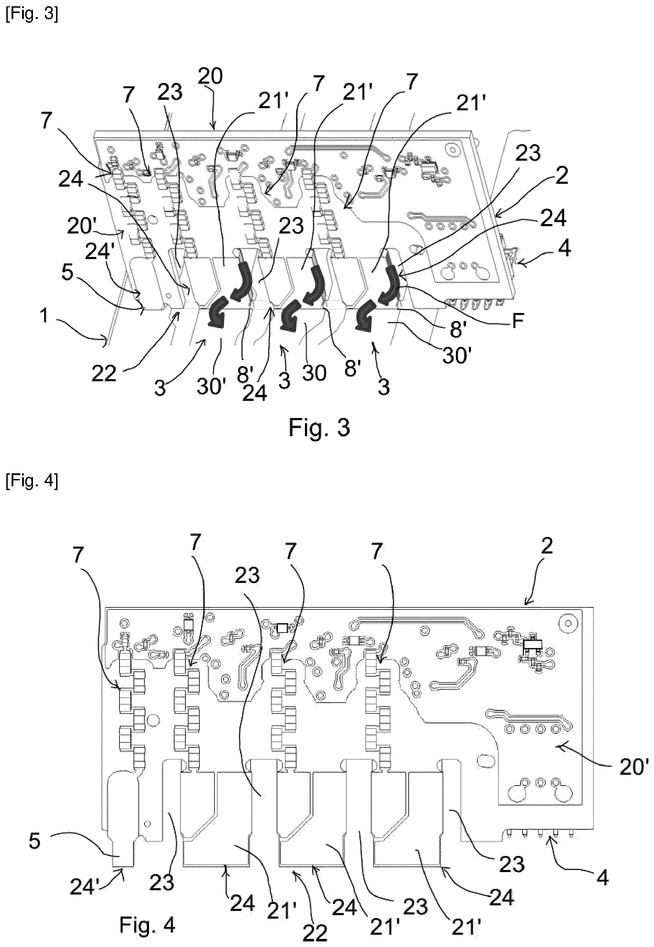

Toujours conformément à la présente invention, la ou chaque piste conductrice 3 comprend une partie principale 30, 30' s'étendant sur la face principale 1a de la carte mère 1 et une partie de transition (ou dit autrement : une partie intermédiaire ou de franchissement) s'étendant sur les deux faces 20, 20' de la carte fille 2 en la traversant. Ainsi la ou chaque piste conductrice 3 forme une surface conductrice avec une continuité électrique en s'étendant sur la face principale 1a de la carte mère 1 d'un côté de la carte fille 2 puis en franchissant la carte fille 2 en la traversant par au moins ouverture/fente /découpe 23 pratiquée à travers l'épaisseur de cette dernière, puis en continuant en s'étendant sur la face principale 1a de la carte mère 1 de l'autre côté de la carte fille 2 (voir notamment les figures 1 et 3).

La ou chaque piste conductrice 3 comprend donc une partie (partie principale 30, 30') dans le plan de la carte mère 1 de part et d'autre de la carte fille 2 et une partie (partie de transition) dans le plan de la carte fille 2. Ainsi la ou chaque piste conductrice 3 s'étend dans deux plans perpendiculaires entre eux.

La partie principale 30, 30' comprend deux segments principaux 30, 30' (situés) de part et d'autre de la carte fille 2, à savoir un premier segment principal 30 et un second segment principal 30', chacun relié, par une liaison conductrice 8, 8', à la partie de transition de ladite piste conductrice 3.

Le flux de courant F comme on peut le voir notamment sur les figures 1 et 3 peut être dans un sens allant d'un côté à l'autre de la carte fille 2 en la traversant et vice versa. Ainsi, selon le produit/l'installation équipé(e) d'un tel dispositif de mesure de carte à circuit imprimé selon la présente invention, pour des applications monophasée ou triphasée, la carte fille 2, qui comprend ainsi le dispositif de mesure et la partie de transition de la ou chaque piste conductrice 3, est capable de mesurer une grandeur électrique/physique (par exemple la tension et/ou le courant comme décrit par la suite) dans les deux sens c'est-à-dire d'un côté à l'autre de la carte, plus particulièrement dans le sens allant du premier segment principal 30 vers le second segment principal 30' de la ou chaque piste conductrice 3 via sa partie de transition ou dans le sens inverse. Le flux de courant F (ou l'énergie) peut ainsi circuler d'un côté de la carte fille 2 et sortir de l'autre côté (et vice-versa).

Une telle piste conductrice 3 peut être définie comme étant une bande de, ou un chemin, en matériau conducteur, par exemple en cuivre comme c'est généralement le cas pour les pistes de circuit imprimé, permettant de faire circuler un courant (ou flux de courant F), par exemple un courant de charge pour un véhicule électrique ou un courant servant à l'alimentation d'un équipement électrique ou d'une installation électrique, et/ou des signaux électriques. La largeur d'une telle piste conductrice 3 est déterminée en fonction du courant qu'elle transporte. Dans la présente invention, une telle piste conductrice 3 est notamment prévue pour transporter un courant dit fort (par exemple entre 16A et 32A). Les pistes conductrices 3 peuvent être agencées selon le schéma du circuit imprimé (carte mère 1, carte fille 2), en tenant compte des connexions nécessaires entre les composants. La présente invention peut prévoir comme nous le verrons par la suite une isolation entre les pistes conductrices 3, c'est-à-dire des espaces (fentes 23) aptes à assurer l'isolation (électrique) entre ces dernières. Par ailleurs le design et le routage (processus de création du chemin des pistes conductrices 3 sur la carte mère 1 pour leur partie principale et sur la carte fille 2 dans leur partie de transition) des pistes conductrices 3 est déterminé de manière à minimiser les interférences. Le routage peut aussi être déterminé ou modifié par exemple en fonction de la situation des composants ou circuits, par exemple du connecteur 4 ou du ou des circuit(s) de mesure de courant ou de tension 6, 7 décrits par la suite, sur la première ou deuxième face 20, 20' de la carte fille 2.

La ou les pistes conductrices 3 peuvent préférentiellement s'étendre en surface sur la carte mère 1 pour leur partie principale et sur la carte fille 2 pour leur partie de transition.

La carte mère 1 et la carte fille 2 peuvent être des circuits imprimés monocouche ou multicouches. Les circuits imprimés peuvent être recouverts d'une couche de protection telle qu'un vernis.

Toujours conformément à la présente invention, le dispositif de mesure est implanté sur la carte fille 2 en étant relié à la ou l'une des parties de transition conductrice(s).

La carte fille 2 peut comprendre au moins un point de référence de potentiel 5 tel que le neutre.

Ainsi, grâce à une telle carte fille 2 portant le dispositif de mesure relié à la partie de transition de la ou chaque piste conductrice 3 et s'étendant dans un plan perpendiculaire au plan de la carte mère 1, la présente invention permet de libérer autant d'espace sur la carte mère 1 pour la réalisation des mesures. En outre la présence du dispositif de mesure sur la carte fille 2 permet d'éviter ou de limiter sur la carte mère 1 des échauffements générés par le fonctionnement du dispositif de mesure. Une telle carte fille 2 permet ainsi d'obtenir un faible encombrement de la partie mesure sur la carte mère 1 et une amélioration de la dissipation thermique lors des mesures par rapport à des mesures effectuées par un dispositif de mesure implanté directement sur la carte mère 1, ceci contrairement aux systèmes actuels.

De préférence, la ou chaque liaison conductrice 8, 8' permet d'établir, pour la ou chaque piste conductrice 3, une liaison métallique réunissant le premier segment principal 30 et le premier segment conducteur 21 de transition et une liaison métallique réunissant le second segment 30' principal et le second segment conducteur 21' de transition. Dans une forme de réalisation préférentielle de la ou chaque liaison conductrice 8, 8', une telle liaison conductrice 8, 8' peut consister préférentiellement en une brasure. L'opération de brasage, notamment et préférentiellement de brasage à la vague, permettant d'obtenir de telles brasures, notamment de telles brasures à la vague, est un procédé d'assemblage permanent qui est choisi pour être appliqué préférentiellement dans le cadre de la présente invention. De telles liaisons conductrices 8, 8' permettent ainsi d'assurer une continuité électrique de la chaque piste conductrice 3 entre sa partie, formée par ses premier et second segments principaux 30, 30', s'étendant sur la carte mère 1 et sa partie, formée par ses premier et second segments de transition 21, 21', s'étendant perpendiculairement sur la carte fille 2. Cette technique du brasage appliquée à la présente invention pour réaliser de telles brasures de liaison, plutôt que d'utiliser des connecteurs, présente notamment les avantages suivants :
- solidité et fiabilité de la liaison : les liaisons conductrices 8, 8' ainsi obtenues par brasage sont solides et fiables, assurant un contact électrique stable et réduisant les risques de desserrement dus aux vibrations ou aux mouvements mécaniques,
- réduction des points de faiblesse et du coût : le brasage permet d'éliminer les composants intermédiaires, comme les broches ou les cosses, qui peuvent être des points de faiblesse ou de défaillance. Cela réduit également les risques de déconnexion accidentelle ou de mauvais contact.
- bonne conductivité électrique et réduction des pertes d'énergie : la brasure confère une conductivité électrique élevée, car elle crée une liaison métallique entre la partie principale 30, 30' de la ou chaque piste conductrice 3 sur la carte mère 1 et sa partie de transition sur la carte fille 2,
- résistance aux influences extérieures : la brasure fournit une protection contre, par exemple, l'humidité, la poussière, et d'autres contaminants.

De préférence, pour pouvoir acheminer les signaux de mesures en dehors de la carte fille 2, celle-ci peut comprendre un connecteur 4 relié au dispositif de mesure (voir notamment les figures 1 à 3). Le connecteur 4 peut être monté en surface sur la première ou deuxième face 20, 20' de la carte fille 2. De préférence le connecteur 4 est monté sur la même face que celle où est monté le dispositif de mesure ou d'au moins l'un des circuits de mesure 6, 7 de ce dernier décrits par la suite.

L'acquisition et le traitement des signaux de mesure (générés par le dispositif de mesure) peuvent être réalisés de préférence par un circuit de traitement, microcontrôleur ou processeur, présent sur la carte mère 1, de préférence sur sa face principale 1a sur laquelle est assemblée/connectée la carte fille 2.

Un tel dispositif de carte à circuit imprimé selon la présente invention peut être configuré pour être appliqué à un réseau monophasé ou multiphasé. Dans le cas d'une application à un réseau monophasé, le dispositif de carte à circuit imprimé peut comporter une seule piste 3 conductrice et une seule transition conductrice.

Dans le cas d'une application à un réseau multiphasé, par exemple triphasé (cas illustré sur les figures 1 à 4), par exemple pour le transport de courants forts (par exemple de l'ordre de 16 A à 32 A), comme on peut le voir sur les figures 1 à 4 annexées, un tel dispositif de carte à circuit imprimé selon la présente invention peut être configuré pour comporter plusieurs pistes conductrices 3, et ainsi plusieurs parties de transitions sur la carte fille 2, de préférence situées les unes à côté des autres, chacune dédiée à l'une des phases. Ainsi, selon une caractéristique de la présente invention, chaque piste conductrice 3 (et donc chaque partie de transition sur la carte fille 2) peut être dédiée à l'une des phases du courant en étant apte et destinée à être parcourue, ou en étant parcourue, par un courant d'une seule phase. Chaque phase a donc sa propre piste conductrice 3, et sa propre transition conductrice sur la carte fille 2. Chaque phase porte un courant en relation de phases avec les autres.

Dans une forme préférentielle de la carte fille 2, comme on se peut le voir sur les figures 1 à 4, la carte fille 2 peut comporter un bord 22, dit bord 22 de connexion et de liaison électrique, parallèle et adjacent à la face 1a principale de la carte mère 1 (ou à la carte mère 1). Le bord 22 de connexion et de liaison électrique peut comprendre sur sa longueur au moins deux fentes 23 transversales et un ou plusieurs plots 24 de connexion et de liaison électrique électriquement séparés entre eux par les fentes 23 transversales délimitant entre elles le ou l'un des plots de connexion 24 et de liaison électrique. Le ou chaque plot 24 de connexion et de liaison électrique est dédié à la ou chaque piste conductrice 3 et présente deux côtés opposés, à savoir un premier côté dans le plan de la première face 20 de la carte fille 2 et un deuxième côté dans le plan de la deuxième face 20' de la carte fille 2, reliés entre eux par des petits côtés 25 (ou chants 25) formant chacun un côté de l'une des fentes 23. La partie de transition de la ou chaque piste conductrice 3 peut alors s'étendre sur les deux côtés du plot 24 de connexion et de liaison électrique dédié et, de préférence, sur au moins l'un des petits côtés 25.

L'une des fentes 23 peut également séparer l'un des plots 24 de connexion et de liaison électrique du point de référence de potentiel 5. Le point de référence de potentiel 5 peut aussi être formé par un plot 24', dit plot 24' de connexion et de référence de potentiel, dédié à une telle référence de potentiel et servir notamment pour la mesure de tension (décrite par la suite).

On comprend que les plots 24 de connexion et de liaison électrique, le cas échéant le plot 24' de référence de potentiel, espacés entre eux par les fentes 23, sont disposés côte à côte (ou alignés) le long du bord de connexion 22 de la carte fille 2.

De préférence, le point de référence de potentiel 5 (ou le plot 24 de référence de potentiel), comme on peut le voir sur les figures 1 à 4, peut être placé à proximité de l'un des bords perpendiculaires au bord 22 de connexion.

De préférence, le connecteur 4 peut être situé à proximité de l'un des bords perpendiculaires au bord 22 de connexion, de préférence à l'opposé du point ou plot 24' de connexion et de référence de potentiel.

Cette forme de réalisation de la carte fille 2 avec les plots 24 et de liaison électrique dédiés chacun à une phase et (électriquement) séparés les uns des autres par les fentes 23 permet d'isoler l'une de l'autre les phases entre elles ou la phase et le neutre.

Si on se réfère maintenant plus particulièrement aux figures 1 à 2, on peut voir que le dispositif de mesure est configuré pour mesurer un courant. A cet effet, on peut voir qu'il peut comprendre au moins un circuit de mesure du courant 6. Le ou chaque circuit de courant 6 est dédié à la partie de transition 20, 21' de la ou l'une des pistes conductrices 3 et est monté en surface sur la première ou deuxième face 20, 20' de la carte fille 2. En outre, la partie de transition de la ou chaque piste conductrice 3 peut comprend un premier segment de transition 21 relié au premier segment principal 30 de la partie principale 30, 30' de la ou l'une des piste(s) conductrice(s) 3 et un second segment de transition 21' relié au second segment principal 30' de la partie principale 30, 30' de la ou l'une des piste(s) conductrice(s) 3. Par ailleurs, le premier segment de transition 21 peut être relié au second segment de transition 21' par l'intermédiaire du circuit de mesure 6 de sorte à permettre à ce dernier de pouvoir mesurer le courant parcourant la partie de transition (dédiée) et ainsi de permettre au dispositif de mesure de mesurer le courant parcourant la ou chaque piste conductrice 3 puisque le courant circulant dans la partie principale 30, 30' de la ou chaque piste conductrice 3 et le même que celui circulant dans la partie de transition correspondante vers le dispositif de mesure.

De préférence, le circuit de mesure du courant 6 peut comprendre au moins un capteur de courant à effet Hall. Il est rappelé que l'effet Hall génère un voltage proportionnel à la densité de flux magnétique. L'utilisation d'un tel capteur à effet Hall permet notamment d'obtenir les avantages suivants :
- mesure sans contact : le capteur à effet Hall 6 permet de mesurer des courants sans établir de connexion électrique directe avec le conducteur. Cela minimise les perturbations dans le circuit et réduit le risque de courts-circuits ou de chocs électriques,
- isolation électrique : comme la mesure est effectuée à travers un champ magnétique, le capteur à effet Hall offre une isolation électrique entre le circuit de mesure à effet Hall et le circuit du courant mesuré (piste conductrice 3). Ceci est particulièrement important pour des raisons de sécurité et de protection des circuits sensibles,
- plage de mesure étendue : le capteur à effet hall permet de mesurer une large gamme de courants, des faibles aux très élevés, ce qui rend le dispositif de mesure, selon la présente invention, polyvalent pour différentes applications,
- réponse rapide : le capteur à effet hall a des temps de réponse rapides, permettant de capturer des variations de courant transitoires ou des pics de courant avec précision,
- durabilité et fiabilité : le capteur à effet hall n'a pas de pièces mobiles, ce qui le rend robuste et durable. Il peut fonctionner dans des environnements difficiles sans subir de dommages mécaniques,
- compatibilité avec les environnements hostiles : le capteur à effet hall résiste bien aux conditions environnementales difficiles, comme les températures extrêmes, l'humidité ou la poussière,

Le choix d'un capteur à effet Hall 6 (ou de la technologie à effet Hall) offre ainsi des avantages significatifs dans la présente invention en termes de sécurité, d'isolation, de flexibilité et de durabilité.

De préférence, le circuit de mesure du courant 6, par exemple comprenant au moins un tel capteur à effet hall, est un circuit intégré. Cette caractéristique, notamment avec le capteur à effet Hall intégré dans le circuit intégré, présente plusieurs avantages notamment en termes d'encombrement (miniaturisation), de coût, de performance et d'intégration avec d'autres composants électroniques. En effet, le circuit intégré, par exemple intégrant un capteur à effet Hall, permet de créer un dispositif plus petit et compact, ce qui est avantageux dans un domaine tel que, par exemple, l'électronique automobile, les bornes de recharges ou encore les compteurs électriques. En outre l'intégration d'un capteur à effet hall dans un tel circuit intégré permet d'améliorer la précision de la mesure et de réduire les interférences électromagnétiques (EMI). Par ailleurs, un capteur à effet Hall offre une isolation électrique par rapport au courant mesuré qui peut être avantageuse dans un circuit intégré où l'isolation est cruciale pour éviter les courts-circuits ou les décharges électriques. Enfin un circuit intégré peut inclure des fonctionnalités supplémentaires (par exemple à celle du capteur à effet Hall intégré dans un tel circuit) comme des circuits de conditionnement de signal, des convertisseurs analogique-numérique (CAN), des fonctions de calibration, et des interfaces numériques. Enfin, l'intégration d'un capteur à effet Hall dans un tel circuit intégré permet audit capteur d'interagir facilement avec d'autres composants électroniques, facilitant ainsi l'interfaçage et la communication avec des microcontrôleurs, des processeurs ou des systèmes de communication.

De préférence, par exemple, la présente invention peut prévoir qu'un tel circuit intégré soit un circuit intégré connu sous la référence ACS37002 de la société ALLEGRO microsystems. Un tel circuit ACS37002 est un capteur de courant à effet hall entièrement intégré et d'une grande précision.

Si on se réfère notamment aux figures 1 et 2, on peut voir que, de préférence, la connexion entre les premier et second segments de transition 21, 21' et le ou chaque circuit de mesure de courant 6 dédié est située sur la face 20, 20' (première ou deuxième face) de la carte fille 2 sur laquelle est monté en surface le circuit de mesure de courant 6. Ainsi, le courant parcourant la ou chaque piste conductrice 3 entre dans le circuit de mesure de courant 6 et sort de ce dernier sur la même face 20, 20' de la carte fille 2. On peut voir notamment sur les figures 1 et 3 que le flux de courant (F) parcourant la ou chaque piste conductrice 3 va dans le sens de la première face 20 de la carte fille 2 vers sa deuxième face 20' et entre dans chaque circuit de mesure 6 en étant acheminé sur la première face 20 de la carte fille par le premier segment de transition 21 puis ressort du circuit de mesure 6 sur la même première face en étant acheminé par le second segment de transition 21', traversant la carte fille 2, vers l'autre côté de la carte fille 2.

Plus particulièrement, sur les figures 1 et 2, on peut voir que chaque circuit de mesure de courant 6, dédié à chaque phase, est monté en surface sur la première face 20 de la carte fille 2 et que, pour chaque circuit de mesure 6 dédié à la partie de transition de l'une des pistes conductrices 3, les points de raccordements 60 (ou les pins ou broches 60 du circuit intégré) du circuit de mesure de courant 6 sont tous situés sur la première face 20 de la carte fille et que, par conséquent, les premier et second segments de transition 21, 21' sont reliés chacun auxdits points de raccordement 60 sur la première face 20 de la carte fille 2. On peut voir également, pour chaque piste conductrice 3 et chaque circuit de mesure de courant 6 dédié :
- que le premier segment de transition 20 s'étend depuis sa liaison conductrice 8 (brasure) avec le premier segment principal 30 du côté de la première face 20 de la carte fille 2 jusqu'aux points de raccordement 60 du circuit de mesure 6 situés du même côté. Dans la forme de réalisation avec les plots de connexion 24, le premier segment de transition 20 s'étend ainsi sur le premier côté 25 du plot 24,
- et que le second segment de transition 21' s'étend depuis sa liaison conductrice 8' (brasure) avec le second segment principal 30' du côté de la deuxième face 20' de la carte fille 2 jusqu'au points de raccordement 60 du circuit de mesure 6 situés de l'autre côté sur la première face 20 de la carte fille 2. On peut voir également que le second segment de transition 21' traverse la carte fille 2 par l'une des fentes 23 en s'étendant sur l'un des petits côtés 26 du plot 24. Dans la forme de réalisation avec les plots de connexion 24, le second segment de transition 21' s'étend ainsi sur les premier et second côtés 25, 25' du plot 24. Sur le premier côté 25 du plot 24, ou plus généralement, sur la première face 20 de la carte fille 2, le premier segment de transition 21 est électriquement séparé du second segment de transition 21', c'est-à-dire que le premier segment de transition 21 est uniquement relié électriquement au second segment de transition 21' par l'intermédiaire du ou de l'un des circuit(s) de mesure de courant 6.

Si on se réfère maintenant aux figures 3 et 4 on peut voir que le ou au moins l'un des circuit(s) de mesure du dispositif de mesure peut être un circuit de mesure de tension 7. Le ou chaque circuit de mesure de tension 7 peut être monté en surface sur la première ou deuxième face 20, 20' de la carte fille 2 en étant relié, d'une part, à la partie de transition de la ou l'une des pistes conductrices 3 et, d'autre part, au point de référence de potentiel 5 sur la carte fille 2 ou à la partie de transition d'une autre piste conductrice 3 de sorte à pouvoir mesurer :
- la tension de phase, c'est à dire entre la tension (de phase) entre la partie de transition de la ou chaque piste conductrice 3 et le point de référence de potentiel 5 et ainsi la tension de phase entre la ou chaque piste conductrice 3 et le point de référence de potentiel 5,
- ou la tension entre les phases, c'est-à-dire la tension (entre les phases) entre les parties de transition de deux pistes conductrices 3 et ainsi entre deux pistes conductrices 3.

De préférence, le ou chaque circuit de mesure de tension 7 est réalisé à partir d'un système de ponts diviseurs, de préférence un système de ponts diviseurs utilisant des amplificateurs opérationnels. De préférence, les ponts diviseurs peuvent être dimensionnés de manière à respecter les distances d'isolation et lignes de fuite. De plus, ces résistances et amplificateurs opérationnels peuvent être choisis dans afin de répondre aux spécifications concernant la tension secteur.

La présente invention peut prévoir, comme on peut le voir sur les figures 1 à 4, que le dispositif de mesure comprenne au moins un tel circuit de mesure de courant 6 et au moins un tel circuit de mesure de tension 7. De préférence, le ou chaque circuit de mesure de courant 6 peut être monté en surface sur l'une des faces 20, 20' de la carte fille 2 et le ou chaque circuit de mesure de tension peut être monté en surface sur l'autre face 20, 20' de la carte fille 2. Ainsi, dans un agencement/ une implantation préférentielle sur la carte fille 2, la partie mesure de courant (le ou les circuits de mesure de courant 6) peut être montée en surface sur la première face 20 (ou l'une des faces) de la carte fille 2 (figures 1 à 2) et la partie mesure de tension (le ou les circuits de mesure de tension) peut être située sur la deuxième face (ou l'autre face) de la carte fille 2 (figures 3 à 4).

De préférence, la carte mère 1 peut être une carte électronique de puissance et/ou de contrôle d'une charge.

Dans un tel dispositif de carte à circuit imprimé selon la présente invention, les grandeurs électriques mesurées par le dispositif de mesure sur la carte fille 2 sont donc plus particulièrement le courant et/ou la tension, et donc aussi la puissance.

Les avantages d'un tel dispositif de carte à circuit imprimé peuvent être notamment, sans être limitatifs en termes d'avantage, :
- un encombrement réduit par la présence d'au moins l'un des éléments/agencements suivants sur la carte fille 2 : dispositif de mesure, connecteur, plots 24 de connexion et de liaison électrique et plot 24' de référence de potentiel agencés côte à côte le long du bord de connexion 22 de la carte fille 2,
- coût (utilisation de circuits intégrés, notamment à capteur à effet Hall),
- les phases peuvent être réattribuées en fonction du produit/routage,
- réalisation des connexion ou liaison électrique entre la carte mère 1 et la carte fille 2 par des brasure (brasage à la vague),
- amélioration de la dissipation thermique.

La présente invention a également pour objet une borne de recharge d'un véhicule électrique ou un véhicule électrique, comprenant un dispositif de carte à circuit imprimé permettant la mesure d'au moins une grandeur électrique.

Conformément à la présente invention, dans une telle borne de recharge d'un véhicule électrique ou un tel véhicule électrique, le dispositif de carte à circuit imprimé consiste en un dispositif de carte à circuit imprimé selon la présente invention.

La présente invention a encore pour objet un compteur électrique/électronique pour mesurer la consommation électrique, comprenant un dispositif de carte à circuit imprimé permettant la mesure d'au moins une grandeur électrique.

Conformément à la présente invention, dans un tel compteur électrique/électronique, le dispositif de carte à circuit imprimé consiste en un dispositif de carte à circuit imprimé selon la présente invention.

De préférence, dans une telle borne de recharge d'un véhicule ou dans un tel compteur électrique/électronique, la carte mère 1 peut être une carte électronique de puissance et/ou de contrôle d'une charge.

La présente invention concerne plus particulièrement le domaine des équipements électriques résidentiels et tertiaires et, plus particulièrement de la recharge électrique des véhicules et des compteurs électriques.

Bien entendu, l'invention n'est pas limitée au mode de réalisation décrit et représenté aux dessins annexés. Des modifications restent possibles, notamment du point de vue de la constitution des divers éléments ou par substitution d'équivalents techniques, sans sortir pour autant du domaine de protection de l'invention.

## Revendications

1. Dispositif de carte à circuit imprimé permettant la mesure d'au moins une grandeur électrique, ledit dispositif comprenant une carte à circuit imprimé (1), dite carte mère (1), présentant une face, dite face (1a) principale, un dispositif de mesure permettant de mesurer au moins une grandeur électrique et de générer des signaux de mesure et au moins une piste conductrice (3) du courant pour la mesure, **caractérisé en ce qu'**il comprend en outre une carte à circuit imprimé additionnel, dite carte fille (2), présentant deux faces opposées, à savoir une première face (20) et une deuxième face (20') et étant connectée directement sur la face (1a) principale de la carte mère (1) en étant maintenue sensiblement perpendiculairement par rapport à la carte mère (1), **en ce que** la ou chaque piste conductrice (3) comprend une partie principale (30, 30') s'étendant sur la face principale (1a) de la carte mère (1) et une partie de transition s'étendant sur les deux faces (20, 20') de la carte fille (2) en la traversant, la partie principale (30, 30') comprenant deux segments principaux (30, 30') de part et d'autre de la carte fille (2), à savoir un premier segment principal (30) et un second segment principal (30'), chacun relié, par une liaison conductrice (8, 8'), à la partie de transition de ladite piste conductrice (3) et **en ce que** le dispositif de mesure est implanté sur la carte fille (2) en étant relié à la ou l'une des parties de transition conductrice(s).

2. Dispositif de carte à circuit imprimé selon la revendication 1, **caractérisé en ce que** la liaison conductrice (8, 8') consiste en une brasure.

3. Dispositif de carte à circuit imprimé selon l'une quelconque des revendications 1 à 2, **caractérisé en ce que** chaque piste conductrice (3) est dédiée à l'une des phases du courant en étant apte et destinée à être parcourue, ou en étant parcourue, par un courant d'une seule phase.

4. Dispositif de carte à circuit imprimé selon l'une quelconque des revendications 1 à 3, **caractérisé en ce que** la carte fille (2) comporte un bord (22) de connexion et de liaison électrique parallèle et adjacent à la face (1a) principale de la carte mère (1), ledit bord (22) de connexion et de liaison électrique comprenant sur sa longueur au moins deux fentes (23) transversales et un ou plusieurs plot(s) (24) de connexion et de liaison électrique électriquement séparés entre eux par les fentes (23) transversales délimitant entre elles le ou l'un des plots de (24) de connexion et de liaison électrique, le ou chaque plot (24) de connexion et de liaison électrique étant dédié à la ou chaque piste conductrice (3) et présentant deux côtés opposés, à savoir un premier côté dans le plan de la première face (20) de la carte fille (2) et un deuxième côté dans le plan de la deuxième face (20') de la carte fille (2), reliées entre eux par des petits côtés (25) formant chacun un côté de l'une des fentes (23) et **en ce que** la partie de transition de la ou chaque piste conductrice (3) s'étend sur les deux côtés du plot (24) de connexion et de liaison électrique dédié et, de préférence, sur au moins l'un des petits côtés (25).

5. Dispositif de carte à circuit imprimé selon l'une quelconque des revendications 1 à 4, **caractérisé en ce que** la carte fille (2) comprend un connecteur (4) permettant d'acheminer les signaux de mesures en dehors de la carte fille (2), ledit connecteur (4) étant relié au dispositif de mesure et monté en surface sur la première ou deuxième face (20, 20') de la carte fille (2).

6. Dispositif de carte à circuit imprimé selon l'une quelconque des revendications 1 à 5, **caractérisé en ce que** le dispositif de mesure comprend au moins un circuit de mesure du courant (6) dédié à la partie de transition (20, 21') de la ou l'une des pistes conductrices (3) et monté en surface sur la première ou deuxième face (20, 20') de la carte fille (2) et **en ce que** la partie de transition de la ou chaque piste conductrice (3) comprend un premier segment de transition (21) relié au premier segment principal (30) de la partie principale (30, 30') de la ou l'une des pistes conductrices (3) et un second segment de transition (21') relié au second segment principal (30') de la partie principale (30, 30') de la ou l'une des pistes conductrices (3) et **en ce que** le premier segment de transition (21) est relié au second segment de transition (21') par l'intermédiaire du circuit de mesure (6) de sorte à permettre à ce dernier de pouvoir mesurer le courant parcourant la partie de transition et ainsi de permettre au dispositif de mesure de mesurer le courant parcourant la ou chaque piste conductrice (3).

7. Dispositif de carte à circuit imprimé selon la revendication 6, **caractérisé en ce que** le circuit de mesure du courant (6) comprend au moins un capteur de courant à effet Hall.

8. Dispositif de carte à circuit imprimé selon l'une quelconque des revendications 6 à 7, **caractérisé en ce que** le circuit de mesure du courant (6) est un circuit intégré.

9. Dispositif de carte à circuit imprimé selon l'une quelconque des revendications 6 à 8, **caractérisé en ce que** la connexion entre les premier et second segments de transition (21, 21') et le ou chaque circuit de mesure de courant (6) dédié est située sur la face (20, 20') de la carte fille (2) sur laquelle est monté en surface le circuit de mesure de courant (6).

10. Dispositif de carte à circuit imprimé selon l'une quelconque des revendications 1 à 9, **caractérisé en ce que** le ou au moins l'un des circuits de mesure est un circuit de mesure de tension (7) et est monté en surface sur la première ou deuxième face (20, 20') de la carte fille (2) en étant relié, d'une part, à la partie de transition de la ou l'une des pistes conductrices (3) et, d'autre part, à un point de référence de potentiel (5) sur la carte fille (2) ou à la partie de transition d'une autre piste conductrice (3) de sorte à pouvoir mesurer la tension de phase entre la partie de transition de la ou chaque piste conductrice (3) et le point de référence de potentiel (5) et ainsi la tension de phase entre la ou chaque piste conductrice (3) et le point de référence de potentiel (5) ou à pouvoir mesurer la tension entre les phases entre les parties de transition de deux pistes conductrices (3) et ainsi entre deux pistes conductrices (3).

11. Dispositif de carte à circuit imprimé selon la revendication 10, **caractérisé en ce que** le ou chaque circuit de mesure de tension (7) est réalisée à partir d'un système de ponts diviseurs, de préférence un système de ponts diviseurs utilisant des amplificateurs opérationnels.

12. Dispositif de carte à circuit imprimé selon l'une quelconque des revendications 6 à 9 prises chacune en combinaison avec l'une quelconque des revendications 10 à 11, **caractérisé en ce que** le ou chaque circuit de mesure de courant (6) est monté en surface sur l'une des faces (20, 20') de la carte fille (2) et le ou chaque circuit de mesure de tension (7) est monté en surface sur l'autre face (20, 20') de la carte fille (2).

13. Dispositif de carte à circuit imprimé selon l'une quelconque des revendications 1 à 12, **caractérisé en ce que** la carte mère (1) est une carte électronique de puissance et/ou de contrôle d'une charge.

14. Borne de recharge d'un véhicule électrique ou véhicule électrique, comprenant un dispositif de carte à circuit imprimé permettant la mesure d'au moins une grandeur électrique, **caractérisé en ce que** ledit dispositif de carte à circuit imprimé consiste en un dispositif de carte à circuit imprimé selon l'une quelconque des revendications 1 à 13.

15. Compteur électrique/électronique pour mesurer la consommation électrique, comprenant un dispositif de carte à circuit imprimé permettant la mesure d'au moins une grandeur électrique, **caractérisé en ce que** ledit dispositif de carte à circuit imprimé consiste en un dispositif de carte à circuit imprimé selon l'une quelconque des revendications 1 à 13.
